# EUROPEAN PATENT APPLICATION

(11) **EP 3 703 350 A1**
(43) Date of publication of application: **02.09.2020**
(21) Application number: 18881244.0
(22) Date of filing: 24.10.2018
(51) Int. Cl.: H04M 1/23

(54) **INPUT DEVICE FOR USE IN SMART TERMINAL, HOUSING, AND SMART TERMINAL**

(30) Priority: 24.11.2017 CN 201721590503 U
(71) Applicant: Shanghai Zhonglian Technologies Ltd., Co, Shanghai 201419 (CN)
(72) Inventor: DUAN, Haitao, Jiangxi 330008 (CN); DING, Zhicheng, Jiangxi 330008 (CN); LI, Peng, Jiangxi 330008 (CN)
(74) Representative: Ridderbusch, Oliver
(86) International application number: PCT/CN2018/111753
(87) International publication number: WO 2019/100896

(57) **Abstract**

The utility model provides an input device for an intelligent terminal, a shell and an intelligent terminal, wherein the input device is in communication connection with the intelligent terminal, and the input device includes at least one operating portion and at least one first fixing portion; the input device is assembled and matched with the intelligent terminal through the shell, and an inside surface of the shell surrounds the intelligent terminal; an outside surface in a vertical direction of the shell is provided with a second fixing portion assembled and matched with the first fixing portion; when the first fixing portion and the second fixing portion are in an assembled state, the input device is located on one side of the shell in a horizontal direction; and when the shell is assembled with the intelligent terminal, an inside surface in a vertical direction corresponding to the second fixing portion is contacted with a top end surface or a bottom end surface of the intelligent terminal. After the technical solution above is implemented, a single-sided installation mode is adopted to support a user to simultaneously perform interactive operations on the input device and a touch screen without sheltering the screen.

## Description

### Technical Field

The utility model relates to the field of input devices, and more particularly, to an input device for an intelligent terminal, a shell and an intelligent terminal.

### Background Art

With the progress of science and technology and economic development, an intelligent terminal with a screen such as a smartphone, a tablet computer and the like is becoming more and more popular, and people can perform an interactive operation with the intelligent terminal through a touch screen or a key on the intelligent terminal. However, when a more complicated interactive operation is performed, such as playing a game, it is difficult to meet requirements of the interactive operation by depending on an input device of the intelligent terminal itself only, which is namely the touch screen and limited keys, and there are problems of insufficient hand-held comfort level, screen sheltering by a thumb during operation of the touch screen and deviation easily occurring on a game control accuracy, thus affecting user's operation experience.

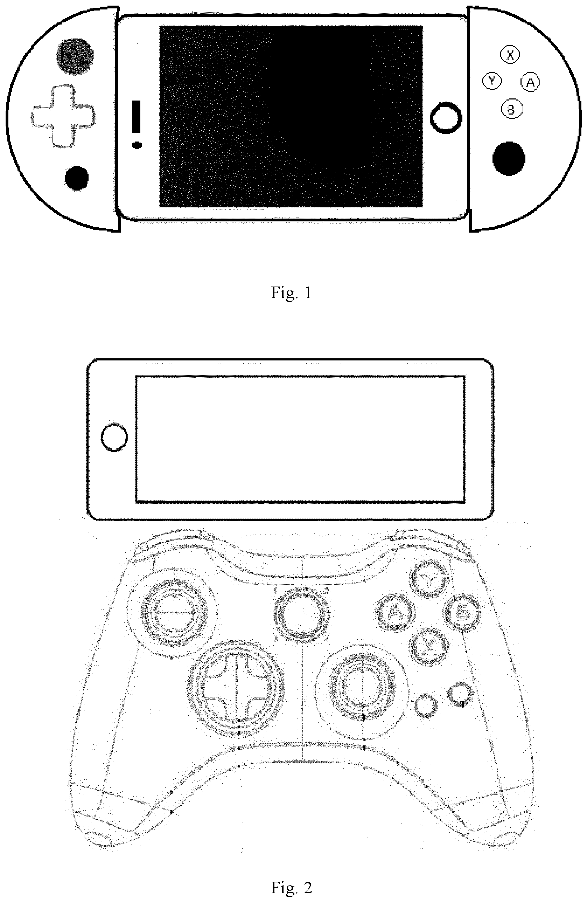

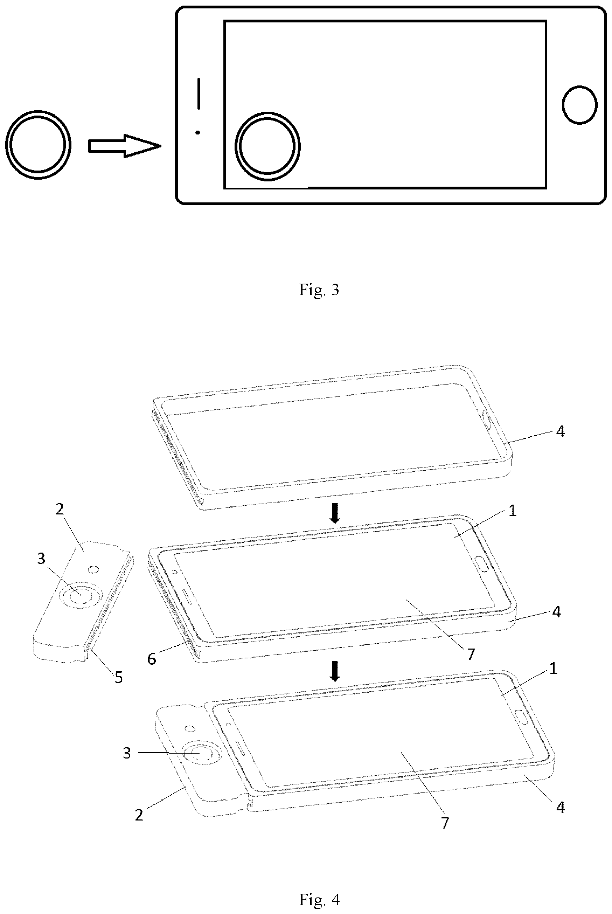

A method of adding an external input device is adopted for the problems above in the prior art, such as a gamepad, and Figs. 1, 2 and 3 show three existing external input devices respectively. In Fig. 1, the intelligent terminal is embedded into the input device, which means that the intelligent terminal and the input device are integrated into a whole, both ends of the intelligent terminal are provided with operating units of the input device, and a user operates the intelligent terminal through a direction key and a function key on the input device. In Fig. 2, the intelligent terminal is separately connected with the external input device. the intelligent terminal only realizes a function of one display screen, and all operations are completed on the external input device. Fig. 3 shows a rocker device for separately replacing the direction key, and the rocker device is directly attached to the screen to replace a virtual rocker displayed through the touch screen and turn the virtual rocker key into a real rocker. The three input devices above have the following problems:
1. the screen can be sheltered during operation, which affects determination of a displayed content, for example, the rocker device in Fig. 3 can shelter the screen;
2. the device is uncomfortable to hold and is not portable, for example, a holding size of an original intelligent terminal is increased in Fig. 1; and
3. the interactive operation is inaccurate, and an operation skill cannot be fully reflected, for example, an auxiliary operation of the touch screen cannot be performed in Fig. 2.

### Summary of the Utility Model

The advantages of the present utility model are further described hereinafter with reference to the drawings and the specific embodiments.

The exemplary embodiments are described in detail herein, and are illustratively shown in the drawings. When the following description refers to the drawings, unless otherwise indicated, the same numbers in different drawings indicate the same or similar elements. The embodiments described in the following exemplary embodiments do not represent all embodiments consistent with the present disclosure. On the contrary, they are merely examples of devices and methods consistent with some aspects of the present disclosure described in detail in the appended claims.

The terms used in the present disclosure are for the purpose of describing particular embodiments only and are not intended to limit the present disclosure. The singular forms of "a", "said" and "the" used in the present disclosure and the appended claims are also intended to include the plural forms, unless other meanings are clearly indicated by the context. It should also be understood that the term "and/or" used herein refers to and includes any or all possible combinations of one or more associated listed items.

It shall be understood that although the terms first, second, third, etc. may be used to describe various information in the present disclosure, the information should not be limited to these terms. These terms are only used to distinguish the information of the same type from each other. For example, the first information can also be referred to as the second information, and similarly, the second information can also be referred to as the first information without departing from the scope of the present disclosure. Depending on the context, the word "if" used herein can be explained as "in the case of", "when" or "in response to determine".

In the description of the present utility model, it should be understood that the orientation or position relation indicated by the terms "longitudinal", "lateral", "upper", "lower", "front", "rear", "left", "right", "vertical", "horizontal", "top", "bottom", "inside", "outside" and the like is based on the orientation or position relation shown in the drawings, which is only used for convenience of description of the present utility model and simplification of description instead of indicating or implying that the indicated device or element must have a specific orientation, and be constructed and operated in a specific orientation, and thus should not be understood as a limitation to the present utility model.

In the description of the present utility model, the terms "installation", "connected" and "connection" should be understood in broad sense unless otherwise specified and defined. For example, they can be mechanical connection or electrical connection, can also be connected inside two components, can be directly connected, and can also be indirectly connected through an intermediate medium. The specific meanings of the above terms can be understood in a specific case by those of ordinary skills in the art.

In the following description, the postfixes such as "module", "component" or "unit" used to indicate elements are only used to facilitate the description of the present utility model and have no specific meanings in themselves. Therefore, the "module" and "component" can be used in a mixed way.

In order to overcome the defects above, the utility model provides an input device which does not shelter a touch screen, a shell matched with the input device during operation, and an intelligent terminal including the shell to support a user to simultaneously operate the input device and the touch screen.

The utility model discloses an input device for an intelligent terminal, the input device is in communication connection with the intelligent terminal and transmits a received input operation to the intelligent terminal, and the input operation is displayed on a screen of the intelligent terminal, wherein the input device includes at least one operating portion and at least one first fixing portion; the input device is assembled and matched with the intelligent terminal through the shell, and an inside surface of the shell surrounds the intelligent terminal; an outside surface of the shell is provided with a second fixing portion assembled and matched with the first fixing portion; when the first fixing portion and the second fixing portion are in an assembled state, the input device is located on one side of the shell in a horizontal direction; and when the shell is assembled with the intelligent terminal, an inside surface in a vertical direction corresponding to the second fixing portion is contacted with a top end surface or a bottom end surface of the intelligent terminal.

Preferably, the first fixing portion and the second fixing portion can be any connecting mechanism of a guide groove, a buckle, a screw, a magnet and a bolt or a combination of at least two of the connecting mechanisms above.

Preferably, the first fixing portion is a cylindrical convex portion; the second fixing portion is a clamping groove, and a shape of an internal space of the clamping groove is adapted to the convex portion; and when the input device is connected with the shell, the convex portion is inserted into the clamping groove.

Preferably, the operating portion includes one or more of a rocker, a button or a rotary knob.

Preferably, the operating portion includes a direction control key formed by a potentiometer.

The utility model further discloses a shell for an intelligent terminal, and an inside surface of the shell surrounds the intelligent terminal, wherein an outside surface of the shell is provided with a second fixing portion assembled and matched with the first fixing portion in the input device above.

Preferably, the first fixing portion is a cylindrical convex portion; the second fixing portion is a clamping groove, and a shape of an internal space of the clamping groove is adapted to the convex portion; and when the input device is assembled with the shell, the convex portion is inserted into the clamping groove.

Preferably, the first fixing portion is a screw fixing position; the second fixing portion is a screw hole; and when the input device is assembled with the shell, the input device is assembled with the screw hole by the screw passing through the screw fixing position.

Preferably, the shell includes an annular portion, and an inside surface of the annular portion surrounds a side surface of the intelligent terminal.

Preferably, the shell includes a bottom surface, and the annular portion is perpendicular to an edge of the bottom surface; and the intelligent terminal is placed in a space formed by the bottom surface and the annular portion, and a back surface of the intelligent terminal is contacted with the bottom surface.

The utility model further discloses an intelligent terminal, which includes the shell above.

The utility model has the following effects after adopting the technical solution above:
1. single-sided installation is adopted to support a user to simultaneously perform interactive operations on the input device and the touch screen;
2. the screen is not sheltered, which is convenient for the user to observe all displayed contents; and
3. a size of the input device is reduced, which is convenient for the user to hold.

### Brief Description of the Drawings

Fig. 1 illustrates an input device in the prior art;
Fig. 2 illustrates another input device in the prior art;
Fig. 3 illustrates another input device in the prior art;
Fig. 4 is a structure diagram complying with an input device for an intelligent terminal and a shell according to a preferred embodiment of the utility model; and

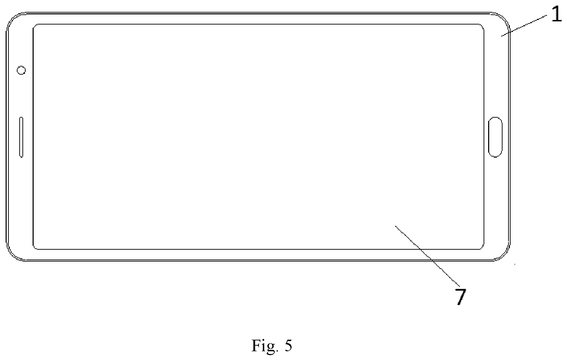

Fig. 5 is a structure diagram complying with the intelligent terminal according to a preferred embodiment of the utility model.

Reference numerals:
1 refers to intelligent terminal, 2 refers to input device, 3 refers to operating portion, 4 refers to shell, 5 refers to first fixing portion, 6 refers to second fixing portion and 7 refers to screen.

### Detailed Description of the Preferred Embodiments

With reference to Fig. 4 which is a structure diagram complying with an input device 2 for an intelligent terminal 1 and a shell 4 according to a preferred embodiment of the utility model, the input device 2 is in communication connection with the intelligent terminal 1 and transmits a received input operation to the intelligent terminal 1, and the input operation is displayed on a screen of the intelligent terminal 1. The input device 2 may be connected with the intelligent terminal 1 by Bluetooth communication, and Bluetooth pairing is required before connection.

The input device 2 includes the following portions.

### - Operating portion 3

The operating portion 3 is a component for receiving a user operation and may be one or more of a rocker, a button or a rotary knob. The input device 2 may be provided with only one operating portion 3 or a plurality of operating portions 3. The operating portions 3 are arranged on a same side surface of the input device 2 for convenience of concentrated distribution and the user operation.

### - First fixing portion 5

The first fixing portion 5 is arranged on a side surface of the input device 2 for installing and fixing the input device 2.

The input device 2 is assembled and matched with the intelligent terminal 1 through the shell 4, and an inside surface of the shell 4 surrounds the intelligent terminal 1. An outside surface of the shell 4 is provided with a second fixing portion 6 matched and connected with the first fixing portion 5. When the first fixing portion 5 and the second fixing portion 6 are in an assembled state, the input device 2 is located on one side of the shell in a horizontal direction. When the shell 4 is assembled with the intelligent terminal 1, an inside surface corresponding to the second fixing portion 6 is contacted with a top end surface or a bottom end surface of the intelligent terminal 1.

In the embodiment, the input device 2 is not directly assembled with the intelligent terminal 1, but is assembled through the shell 4. An outline of the mainstream intelligent terminal 1 is usually designed as a relatively smooth surface without a structure for mechanical installation such as a buckle, a recess and the like. Therefore, a component that can surround the intelligent terminal 1 such as the shell 4 is required to be used as a bridge, and an internal space of the shell 4 is matched with an external size of the intelligent terminal 1. When using the intelligent terminal 1, people often install a jacket for the intelligent terminal 1, such as a mobile phone shell. Therefore, such jacket can be used as the shell 4 without adding a new component, achieving two things at one stroke. Connection between the input device 2 and the shell 4 is realized by assembling and matching the first fixing portion 5 with the second fixing portion 6. Since the inside surface in the vertical direction corresponding to the second fixing portion 6 is contacted with the top end surface or the bottom end surface of the intelligent terminal, the intelligent terminal 1 is located on one side of the inside surface corresponding to the second fixing portion 6 after installation, and the first fixing portion 5 is located on one side of an outside surface where the second fixing portion 6 is located, which means that the input device 2 is located on one side of the outside surface where the second fixing portion 6 is located. Therefore, the input device 2 and the intelligent terminal 1 are located on both sides of the second fixing portion 6 respectively, thus realizing an installation mode of installing the input device 2 on one end of the intelligent terminal in a single-sided manner.

When the input device 2 is connected with the intelligent terminal 1, the intelligent terminal 1 is put into the shell 4 firstly, and then the input device 2 is connected with the shell 4. When the input device 2 is connected, the operating portion 3 and the screen 7 are ensured to be arranged on a same side to facilitate the user operation.

Further, the first fixing portion 5 and the second fixing portion 6 may be any connecting mechanism of a guide groove, a buckle, a screw, a magnet and a bolt or a combination of at least two of the connecting mechanisms above. The improved embodiment further defines a preferred mode of using the first fixing portion 5 and the second fixing portion 6 as the connecting mechanisms to connect and fix the input device 2 with the shell 4. The connecting mechanism may be a guide groove, a buckle, a screw, a magnet, a bolt and other specific implementation structures, and any one of the structures may be selectively used for connection, or two or more of the connecting mechanisms may be selectively used to realize the first fixing portion 5 and the second fixing portion 6. When the connecting mechanism is the guide groove, the first fixing portion 5 or the second fixing portion 6 is the guide groove, and correspondingly, the second fixing portion 6 or the first fixing portion 5 is a convex portion matched with the guide groove. When the connecting mechanism is the buckle, the first fixing portion 5 or the second fixing portion 6 is the buckle, and correspondingly, the second fixing portion 6 or the first fixing portion 5 is a clamping portion matched with the buckle. When the connecting mechanism is the screw, the first fixing portion 5 or the second fixing portion 6 is provided with a screw hole matched with the screw, and correspondingly, the second fixing portion 6 or the first fixing portion 5 is provided with a screw fixing position allowing the screw to pass through. When the connecting mechanism is the magnet, the first fixing portion 5 or the second fixing portion 6 is provided with the magnet, and correspondingly, the second fixing portion 6 or the first fixing portion 5 is provided with a ferromagnetic metal or a magnet. When the connecting mechanism is the bolt, the first fixing portion 5 or the second fixing portion 6 is provided with a bolt hole matched with the bolt, and correspondingly, the second fixing portion 6 or the first fixing portion 5 is provided with a bolt fixing position allowing the bolt to pass through.

Further, the first fixing portion 5 is a cylindrical convex portion; the second fixing portion 6 is a clamping groove, and a shape of an internal space of the clamping groove is adapted to the convex portion; and when the input device 2 is connected with the shell 4, the convex portion is inserted into the clamping groove. The first fixing portion 5 is matched and connected with the second fixing portion 6 by a clamping groove connection mode in the improved embodiment, which is convenient for the user to disassemble, and when the input device 2 does not need to be used, the input device 2 can be disassembled by sliding in an extension direction of the clamping groove.

Further, the convex portion is a trapezoid, and an upper bottom edge of the trapezoid is connected with the input device 2. A cross-sectional area of the convex portion is a trapezoid, and the upper bottom edge of the trapezoid is a shorter one of two parallel edges of the trapezoid, so that the upper bottom edge of the trapezoid is connected with the input device 2 through such setting, and a lower bottom edge of the trapezoid faces outwardly. When the convex portion is connected with the clamping groove, the convex portion is firmly fixed in the clamping groove due to an action of the trapezoid, and the input device 2 cannot move in a height direction of the trapezoid but can only slide in a direction of a column side of the convex portion. Correspondingly, the second fixing portion 6, which is namely the internal space of the clamping groove, is also a trapezoid corresponding to a size of the convex portion.

Further, the cross section of the convex portion is an asymmetrical shape; and when the input device 2 is connected with the shell 4, a side surface where the operating portion 3 is located has a unique orientation. Such design is to ensure that the operating portion 3 and the screen 7 of the intelligent terminal 1 remain on a same side. If the cross section of the convex portion is a symmetrical shape, when the input device 2 is connected with the shell 4, a surface where the operating portion 3 is located can face upwardly or downwardly, thus having a possibility of installation in two directions. The cross section of the convex portion in the asymmetrical shape is adopted in the improved embodiment, so that the input device 2 can only be installed according to one orientation, and meanwhile, only an orientation of a surface where the screen 7 is located can be ensured to be determined when the intelligent terminal 1 is put into the shell 4. The shell 4 can also be designed as a recess shape with only one unclosed surface, then an installation mode of the intelligent terminal 1 shall be the surface where the screen 7 is located facing the non-closed surface, so that installation orientations of the input device 2 and the intelligent terminal 1 can be determined, and the operating portion 3 and the screen 7 are endured to be arranged on the same side. Correspondingly, a cross section of the second fixing portion 6, which is namely the internal space of the clamping groove, is also an asymmetrical shape corresponding to a size of the cross section of the convex portion.

In other embodiments of the utility model, the convex portion may also be in an I-shape, a T-shape and other shapes.

In another embodiment of the utility model, the first fixing portion 5 is a screw fixing position; and the second fixing portion 6 is a screw hole. When the input device 2 is connected with the shell 4, the input device is connected with the screw hole by the screw passing through the screw fixing position. A screw fixing mode is adopted in the embodiment, the screw fixing position may be a sheet respectively extending from both ends of one side surface of the input device 2, the sheet is provided with a hole, the screw passes through the hole to be matched and connected with the second fixing portion 6, and the screw hole is provided with an internal screw thread matched with the screw.

Further, the screw hole on an asymmetrical position is arranged in the shell 4, and a correspondingly asymmetrical screw fixing position is arranged on the input device 2, so that the screw fixing position can only be installed when the screw fixing position is corresponding to the screw hole position to ensure that the operating portion 2 has a unique orientation.

In other embodiments of the utility model, a connection mode of the input device 2 and the shell 4 may also be buckle connection, which means that the input device 2 and the shell 4 have corresponding buckle structures; and the connection mode may also be guide real connection, and the input device 2 and the shell 4 are respectively provided with a guide rail and a clamping portion corresponding to the guide rail.

As a further improvement to the input device 2, the operating portion 3 includes one or more of a rocker, a button or a rotary knob. The input device 2 may be provided with different types of operating portions 3, such as a combination of the rocker and the button, or a combination of the rotary knob and the button, and may also be provided with only one operating portion 3. The operating portion 3 may be a direction control key formed by a potentiometer, which supports the user to operate in multiple directions, thus having a better operation flexibility.

As a further improvement to the shell 4, the shell 4 includes an annular portion, and an inside surface of the annular portion surrounds a side surface of the intelligent terminal. Since an outline of the intelligent terminal 1 is a smooth continuous surface, a better fixing effect can only be realized by surrounding the side surface of the intelligent terminal, especially a narrow side surface, thus preventing the intelligent terminal 1 from sliding out of the shell 4.

Further, the shell 4 includes a bottom surface, and the annular portion is perpendicular to an edge of the bottom surface. The intelligent terminal 1 is placed in a space formed by the bottom surface and the annular portion, and a back surface of the intelligent terminal 1 is contacted with the bottom surface. In the improved embodiment, the shell 4 forms a semi-closed space with only one hollowed-out surface, which means that a surface corresponding to the bottom surface is hollowed out, and the intelligent terminal 1 is allowed to be put into the shell 4 from the hollowed-out surface, while the screen 7 of the intelligent terminal 1 is ensured to have a unique orientation.

Further, the shell 4 includes an upper cover portion, and the upper cover portion is movably connected with a long edge of the annular portion, and is in an opened state or a closed state respectively. The upper cover portion is correspondingly arranged with the bottom surface in a movable connection mode, and can be turned over and moved at a joint with the annular portion by a shaft. Use states of the intelligent terminal 1 under different conditions are considered in the improved embodiment, when the input device 2 is used, the upper cover portion is opened to expose the screen 7, which is convenient for the user to watch the screen 7, and when the screen 7 is a touch screen, a touch operation can also be performed. When the input device 2 is not used or the intelligent terminal 1 is not used by the user, the upper cover portion is closed, and the screen 7 is sheltered by the upper cover portion, which protects the screen 7 from external damage.

In other embodiments of the utility model, the input device 2 and the shell 4 are integrally formed, such as an integrated plastic structure or an integrated metal structure, which also solves a problem on how to connect the input device 2 with the intelligent terminal 1.

The utility model further discloses an intelligent terminal 1, which includes the shell 4 above. The intelligent terminal 1 may be designed to include the shell 4 with the second fixing portion 6, so that the shell 4 and the intelligent terminal 1 are connected with the input device 2 as a whole.

The screen 7 may be the touch screen, when the user uses the screen, the intelligent terminal 1 is placed horizontally, and one hand can operate the input device 2 while the other hand can operate the touch screen.

It should be noted that the embodiments of the present utility model have a better implementation performance and are not intended to limit the present utility model in any form. Those skilled in the art may change or decorate the technical contents disclosed above into equivalent effective embodiments. Any modification or equivalent change and decoration to the embodiments above according to the technical essence of the present utility model without departing from the contents of the technical solutions of the present utility model should still fall within the scope of the technical solutions of the present utility model.

## Claims

1. An input device for an intelligent terminal, the input device being in communication connection with the intelligent terminal and transmitting a received input operation to the intelligent terminal, and the input operation being displayed on a screen of the intelligent terminal, wherein:
the input device comprises at least one operating portion and at least one first fixing portion;
the input device is assembled and matched with the intelligent terminal through the shell, and an inside surface of the shell surrounds the intelligent terminal;
an outside surface of the shell is provided with a second fixing portion assembled and matched with the first fixing portion;
when the first fixing portion and the second fixing portion are in an assembled state, the input device is located on one side of the shell in a horizontal direction; and
when the shell is assembled with the intelligent terminal, an inside surface in a vertical direction corresponding to the second fixing portion is contacted with a top end surface or a bottom end surface of the intelligent terminal.

2. The input device according to claim 1, wherein:
the first fixing portion and the second fixing portion can be any connecting mechanism of a guide groove, a buckle, a screw, a magnet and a bolt or a combination of at least two of the connecting mechanisms above.

3. The input device according to claim 1 or 2, wherein:
the first fixing portion is a cylindrical convex portion;
the second fixing portion is a clamping groove, and a shape of an internal space of the clamping groove is adapted to the convex portion; and
when the input device is connected with the shell, the convex portion is inserted into the clamping groove.

4. The input device according to claim 1 or 2, wherein:
the operating portion comprises one or more of a rocker, a button or a rotary knob.

5. The input device according to claim 4, wherein:
the operating portion comprises a direction control key formed by a potentiometer.

6. A shell for an intelligent terminal, an inside surface of the shell surrounding the intelligent terminal, wherein:
an outside surface of the shell is provided with a second fixing portion assembled and matched with the first fixing portion in the input device according to claim 1.

7. The shell according to claim 6, wherein:
the first fixing portion is a cylindrical convex portion;
the second fixing portion is a clamping groove, and a shape of an internal space of the clamping groove is adapted to the convex portion; and
when the input device is assembled with the shell, the convex portion is inserted into the clamping groove.

8. The shell according to claim 6, wherein:
the first fixing portion is a screw fixing position;
the second fixing portion is a screw hole; and
when the input device is assembled with the shell, the input device is assembled with the screw hole by the screw passing through the screw fixing position.

9. The shell according to claims 6 to 8, wherein:
the shell comprises an annular portion, and an inside surface of the annular portion surrounds a side surface of the intelligent terminal.

10. The shell according to claim 9, wherein:
the shell comprises a bottom surface, and the annular portion is perpendicular to an edge of the bottom surface; and
the intelligent terminal is placed in a space formed by the bottom surface and the annular portion, and a back surface of the intelligent terminal is contacted with the bottom surface.

11. An intelligent terminal comprising the shell according to claim 6.
